Europäisches Patentamt

European Patent Office

Office européen des brevets

(11) Publication number: **0 347 157**
**A2**

## (12) EUROPEAN PATENT APPLICATION

(21) Application number: **89305944.4**

(51) Int. Cl.⁴: **H01L 31/06**

(22) Date of filing: **13.06.89**

(30) Priority: **17.06.88 JP 149715/88**

(43) Date of publication of application:
**20.12.89 Bulletin 89/51**

(84) Designated Contracting States:
**DE FR GB**

(71) Applicant: **NEC CORPORATION**
**33-1, Shiba 5-chome, Minato-ku**
**Tokyo 108(JP)**

(72) Inventor: **Watanabe, Isao c/o NEC Corporation**
**33-1, Shiba 5-chome**
**Minato-ku Tokyo(JP)**
Inventor: **Makita, Kikuo c/o NEC Corporation**
**33-1, Shiba 5-chome**
**Minato-ku Tokyo(JP)**
Inventor: **Fukushima, Kiyoshi c/o NEC**
**Corporation**
**33-1, Shiba 5-chome**
**Minato-ku Tokyo(JP)**
Inventor: **Torikai, Toshitaka c/o NEC**
**Corporation**
**33-1, Shiba 5-chome**
**Minato-ku Tokyo(JP)**

(74) Representative: **Abnett, Richard Charles et al**
**REDDIE & GROSE 16 Theobalds Road**
**London WC1X 8PL(GB)**

(54) **Pin semiconductor light receiving device.**

(57) A PIN semiconductor light receiving device includes a light absorbing layer (3), a cap layer (4) provided on the light absorbing layer, and a conduction region (5) of a conduction type different from that of the cap layer which is formed in a predetermined depth of the cap layer. The bandgap energy of the cap layer is increased as the distance from the boundary interface betv . n the cap layer and the light absorbing layer is increased, continuously or in a step-wise manner. Consequently, a PIN semiconductor receiving device of high speed response can easily be fabricated without the necessity of controlling the position of a p-n junction to high precision.

FIG.3

LIGHT INPUT

6 INSULATION LAYER    7 p-ELECTRODE

5 p⁺- CONDUCTION REGION
4 n⁻CAP LAYER
9 n⁻-INTERMEDIATE CAP LAYER
3 n⁻-LIGHT ABSORBING LAYER
2 n-InP BUFFER LAYER
1 n⁺-InP SUBSTRATE

8 n-ELECTRODE

## PIN SEMICONDUCTOR LIGHT RECEIVING DEVICE

### FIELD OF THE INVENTION

The invention relates to a PIN semiconductor light receiving device, and more particularly to a PIN photodiode in which a high speed response is obtained.

### BACKGROUND OF THE INVENTION

In an optical communication system of a high speed and a large capacity, or an optical communication system for a subscriber system, a semiconductor light receiving device in which a high speed response such as an order of Gb/s is obtained and the fabrication process is simple is required to be developed. For this purpose, the research of an InGaAs/InP system PIN photodiode which can be applied to optical communication systems including silica system optical fibers having a low loss wavelength bandwidth of 1.0 $\mu$m to 1.6 $\mu$ m has been actively carried out to improve a high speed response characteristic and simplify a process for fabricating the PIN photodiode in these years. In the PIN photodiode, a semiconductor depletion region is utilized to absorb light, thereby generating photo-carriers. An impurity concentration of the depletion region, that is, that of a light absorbing layer is required to be sufficiently as low as less than $1 \times 10^{16} cm^{-3}$, because a depletion layer must be thick in view of a quantum efficiency. For the purpose of providing a depletion region, a p-n junction is required to be included in a semiconductor. A process for forming a p-n junction is to diffuse p-impurities into an n-semiconductor preferentially in a planar structure of a high reliability. On the other hand, it is required that photo-carriers are not generated in a p-impurity diffused region which is of a high concentration and to which no electric field is applied in view of a response speed and a sensitivity. In other words, it is required that the p-impurity diffused region is a window layer of a wide bandgap energy in which no light absorption is produced. Further, it is required that an original n-layer which will be a p-window region later by a preferential thermal diffusion is of a low impurity concentration of less than $1 \times 10^{16} cm^{-3}$ to reduce dark current causing a deterioration of a receiving sensitivity. That is, a PIN photodiode is required to be a planar structure including a window cap layer and a light absorbing layer which are of a sufficient low impurity concentration, and a p-n junction preferentially formed. In such a planar structure heterojunction PIN photodiode, the position control of a p-n junction is very important in forming a p-n junction to provide a high speed response of a Gb/s order.

This will be explained in a conventional planar structure InGaAs/InP PIN photodiode which is described on pages 654 to 656 of "Electronics Letters, 2nd, August 1984, Vol. 20, No. 16". The conventional planar structure PIN photodiode comprises an $n^{+}$-InP substrate, and an n-InP buffer layer, an $n^{-}$-InGaAs light absorbing layer, and an $n^{-}$-InP window cap layer successively grown on the InP substrate. The conventional PIN photodiode further comprises a $p^{+}$-Zn diffused region formed in the entire thickness of the $n^{-}$-InP window cap layer and a depth "d" from the upper surface of the $n^{-}$- InGaAs light absorbing layer, an insulation layer provided on the $n^{-}$-InP window cap layer including the $p^{+}$-Zn diffused region, a p-electrode connected through the insulation layer to the $p^{+}$-Zn diffused region, and an n-electrode provided on the back surface of the $n^{+}$-InP substrate. In the PIN photodiode, the window cap layer is of a bandgap energy wider than that of the light absorbing layer, and the aforementioned depth "d" is less than approximately 0.2 $\mu$m substantially equal to 10% of 1 to 2 $\mu$m which is the thickness of the light absorbing layer. The ratio of the depth to the thickness of the light absorbing layer has been determined to be "10%" experientially. This is why a response speed characteristic is deteriorated dependent on a diffusion transit time of photo-carriers which are required to transit through the $p^{+}$-diffused region by carrier diffusions, due to the fact that a bias electric field is not applied across a portion of the $p^{+}$-diffused region which is not under a depletion state in the light absorbing layer, because a diffusion speed is less than a saturation drift speed by one order of magnitude, where the $p^{+}$n junction front is positioned too deep in the light absorbing layer. On the other hand, a response is also deteriorated in the PIN photodiode, where the $p^{+}$n junction front is formed in the window cap layer, so that the transit of photo-carriers (holes) is prevented due to a hetero-barrier ($\Delta$ Ev) based on a Valence band. In InP/InGaAs system, the value " $\Delta$Ev" is 0.38 eV which is greater than an average energy of photo-carriers at the time of an electric field application.

As described above, the position control of the p-n junction, that is, the diffusion control of p-impurities is very important in fabricating a PIN photodiode. However, it occurs usually that a position of the p-n junction deviates from a predetermined position in a presently available diffusion technology by 0.5 $\mu$ m at the maximum. Assuming that a p-n junction is formed in a window cap layer with a deviation of 0.5 μm from a heterojunction interface between the window cap layer and a light absorbing layer, the maximum electric field of the p-n junction is less than 350 KV/cm, so that an avalanche amplification is not produced, because an impurity concentration of the window cap layer is less than $1 \times 10^{16} cm^{-3}$, and a tunnel breakdown electric field in InGaAs layer is 250 KV/cm.

For these reasons, the $p^+$-Zn diffused region must be formed with a high precision such as less than 0.1 μm in depth to provide a PIN photodiode of a high speed response.

According to the conventional planar structure InGaAs/InP PIN photodiode, however, there is a disadvantage that it is difficult to form a $p^+$-conduction region having a precision less than 0.1 μm in an $n^-$-light absorbing layer by a presently available thermal diffusion process. As a result, there is a further disadvantage that a yield in fabricating the PIN photodiode is lowered.

## SUMMARY OF THE INVENTION

According to invention, a PIN semiconductor light receiving device comprises a substrate of a first conduction type or a semi-insulation type, a buffer layer of the first conduction type, a light absorbing layer of the first conduction type and a cap layer of the first conduction type successively grown on the substrate, and a conduction region of a second conduction type formed in the cap layer. In the PIN semiconductor light receiving device, a Valence-band offset energy of the cap layer is increased in a step or continuous manner as a distance from a boundary interface between the light absorbing layer and the cap layer is increased in the cap layer.

## BRIEF DESCRIPTION OF DRAWINGS

The invention will be explained in more detail in conjunction with appended drawings wherein,

Fig. 1 is a cross sectional view showing a conventional PIN semiconductor light receiving device,

Fig. 2 and 3 are cross sectional views showing PIN semiconductor light receiving devices in first and second embodiments according to the invention, and

Fig. 4 is an explanatory diagram showing bandgap energies of the PIN semiconductor light receiving devices in the first and second embodiments.

## DESCRIPTION OF PREFERRED EMBODIMENTS

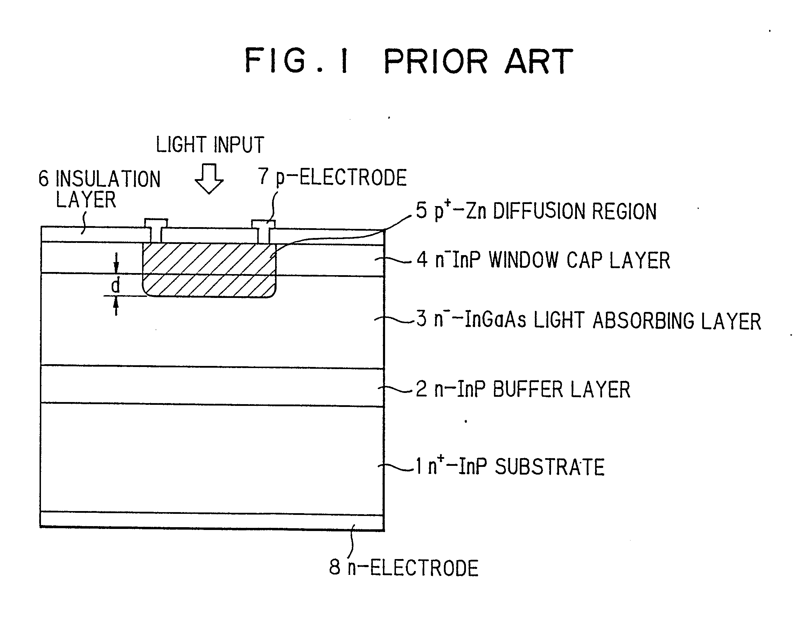

Before explaining a semiconductor light receiving device in a first embodiment according to the invention, the aforementioned conventional semiconductor light receiving device will be explained in Fig. 1.

The Conventional PIN semiconductor light receiving device comprises an $n^+$-InP substrate 1, an n- InP buffer layer 2, an $n^-$-InGaAs light absorbing layer 3, an $n^-$-InP window cap layer 4, a $p^+$-Zn diffusion region 5, an insulation film 6, a p-electrode 7, and an n-electrode 8. The $p^+$-Zn diffused region 5 is formed in the entire thickness of the window cap layer 4 and in the depth "d" from the upper surface of the light absorbing layer 3. A dimension of the depth "d" is set to be less than approprimately 0.2 μm which is determined experientially to be 10% of a thickness of the light absorbing layer 3, where the thickness of the light absorbing layer 3 is usually 1 to 2 μm.

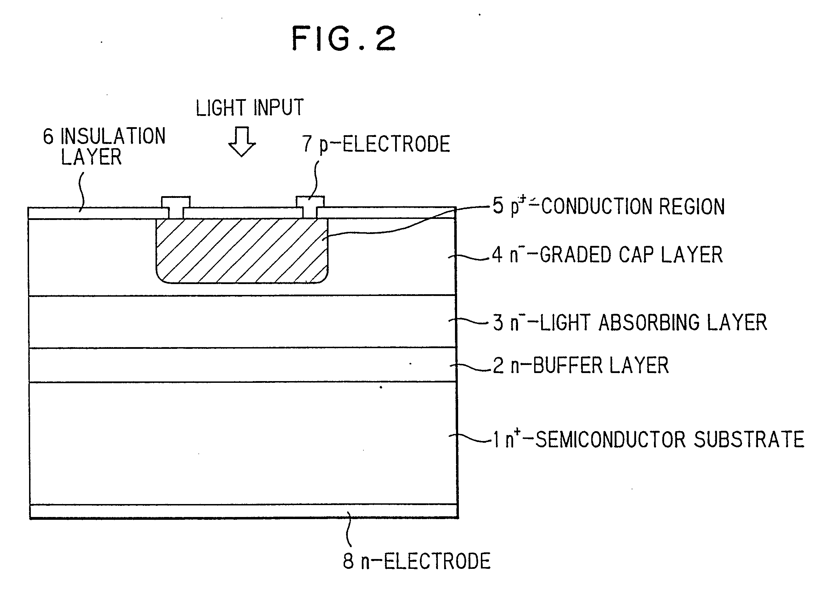

Next, a PIN semiconductor light receiving device in the first embodiment according to the invention will be explained in Fig. 2. The PIN semiconductor light receiving device comprises an $n^+$-semiconductor substrate 1, an n-buffer layer 2, an $n^-$-light absorbing layer 3, an $n^-$-graded cap layer 4, a $p^+$-conduction region 5, an insulation film 6, a p-electrode 7, and an n-electrode 8. In the PIN semiconductor light receiving device, a Valence band discontinuity ($\Delta Ev$) of the graded cap layer 4 is increased continuously from a boundary interface between the light absorbing layer 3 and the graded cap layer 4, and an impurity concentration of the graded cap layer 4 is sufficiently low to provide a depletion layer reaching approximately the bottom surface of the light absorbing layer 3.

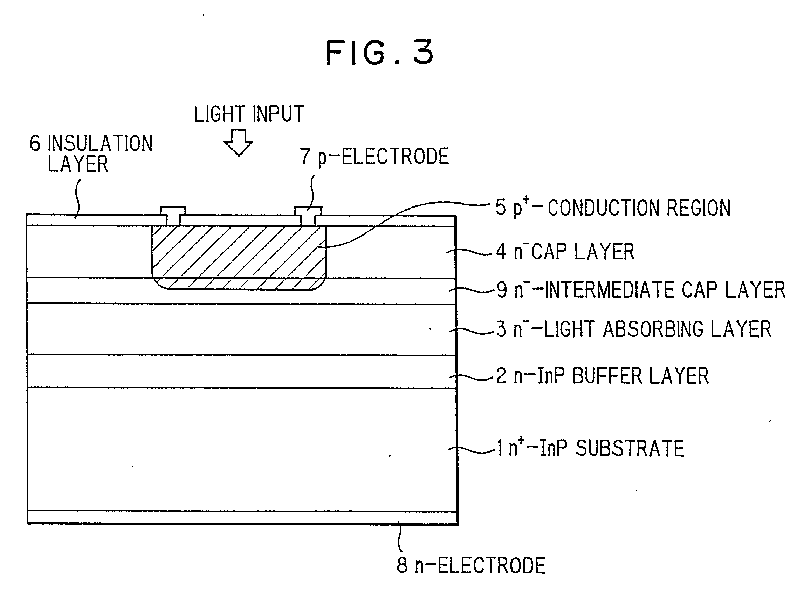

A PIN semiconductor light receiving device in the second embodiment according to the invention will be explained in Fig. 3, wherein like parts are indicated by like reference numerals in Fig. 2, except that an $n^-$-intermediate cap layer 9 is further provided between an $n^-$-light absorbing layer 3 and an $n^-$-non-graded cap layer 4, such that a Valence band discontinuity ($\Delta Ev$) is increased in a step manner from a boundary interface of the light absorbing layer 3. An impurity concentration of the cap layer 4 is controlled in the same manner as in the first embodiment, although there is a difference that it is not graded.

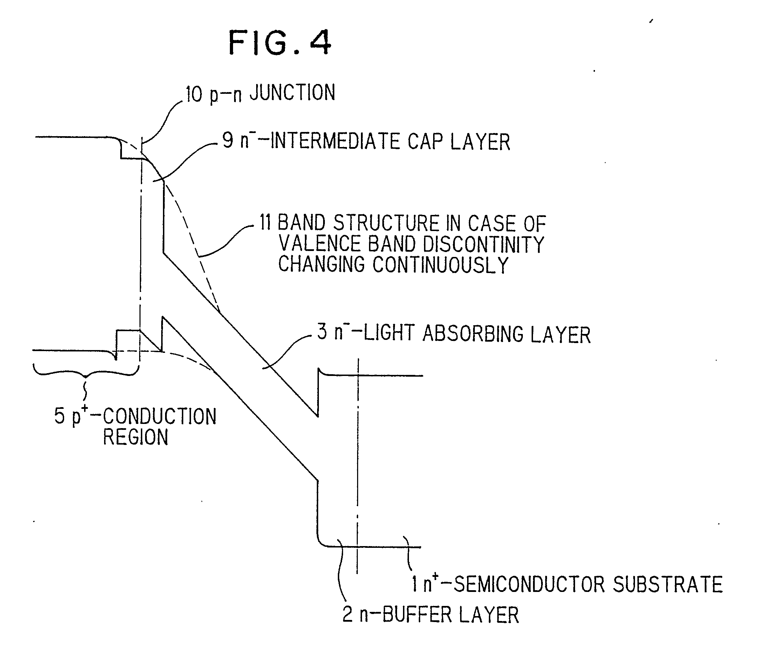

Principle and operation of the invention will be explained in Fig. 4, wherein like parts are indicated by like reference numerals in Figs. 2 and 3. In the bandgap energy structure, a dash-dotted line 10 indicates a position of a p-n junction, and dotted lines 11 indicate a Valence band discontinuity ($\Delta Ev$) changing continuously. The p-n junction is positioned in the graded cap layer 4 in the first embodiment and in the intermediate cap layer 9 in the second embodiment. In any case, the Valence band discontinuity ( ΔEv) is increased as a distance is increased from a boundary interface of the light absorbing layer 3 as described before, so that hole-carriers generated in the light absorbing layer 3 are not interrupted to transit by a hetero-barrier ( Δ Ev). In the invention, therefore, a position of the p-n junction becomes easy to be controlled to such an extent proportional to a thickness of the cap layer 4. Consequently, control in which the position is determined is relieved. For this reason, a planar structure PIN photodiode of a high speed response can be easily fabricated with a relieved precision in depth of a $p^+$-conduction region formed in an $n^-$-cap layer.

The PIN semiconductor light receiving device as shown in Fig. 2 will be fabricated in a following process.

On a (100) $n^+$-InP substrate 1 doped with Sulfer, an n-InP buffer layer 2 having a thickness of 1 μ m, an $n^-$-$In_{0.53}Ga_{0.47}As$ light absorbing layer 3 having a thickness of 1 to 1.5 μm and an impurity concentration of $2 \times 10^{15} cm^{-3}$, and an $n^-$-InGaAsP ~ InP graded cap layer 4 having a thickness of 1.5 μm and an impurity concentration of $2 \times 10^{15}$ to $1 \times 10^{16} cm^{-3}$ are successively grown at atmospheric pressure and a temperature of 650° C by use of an organic metal vapor phase epitaxy, wherein the InGaAsP ~ InP graded cap layer 4 is lattice-matched to InP, and a bandgap energy of the graded cap layer 4 is increased continuously as a distance is increased from a boundary interface of the light absorbing layer 3. Next, SiO₂ film is formed with a thickness of 200 ηm at a temperature of 370° C by a thermal CVD process, and a preferential diffusion circular mask having a diameter of 20 μm is formed in the SiO₂ film by a photolithography process. Then, Zn is diffused through the circular mask into the graded cap layer 4 at a temperature of 520° C for 15 to 16 minutes to provide a p-n junction by a depth of 1.2 to 1.6 μ m. A partial or the entire thickness of the graded cap layer 4 becomes a $p^+$-region to provide the $p^+$-diffused region 5. Next, SiN insulation layer 6 is formed with a thickness of 200 m at a temperature of 250° C for 8 minutes by a plasma CVD process. Finally, a p-electrode 7 of AuZn and an n-electrode 8 of AuGe are provided by a vacuum evaporation process. In the provision of the graded cap layer 4, the position control of the p-n junction is relieved from less than 0.1 μm to less than 0.4 μ m without inviting a deterioration of a frequency response in a bandwidth of 20 GHz.

The PIN semiconductor light receiving device as shown in Fig. 3 will be fabricated in a following process.

On a (100) $n^+$-InP substrate 1 doped with Sulfer, an n-InP buffer layer 2 having a thickness of 1 μm, an $n^-$-$In_{0.53}Ga_{0.47}As$ light absorbing layer 3 having a thickness of 1 to 1.5 μ m and a carrier concentration of less than $2 \times 10^{15} cm^{-3}$, an $n^-$-$In_{0.52}Al_{0.48}As$ intermediate cap layer 9 having a thickness of 0.5 μ m and a carrier concentration of $2 \times 10^{15}$ to $1 \times 10^{16} cm^{-3}$, an InP cap layer 4 having a thickness of 1 μ m and a carrier concentration of $1 \times 10^{15}$ to $2 \times 10^{16} cm^{-3}$ are successively grown at a normal pressure and a temperature of 700° C by use of an organic metal vapor phase epitaxy. Valence band discontinuities ( Δ Ev) for $In_{0.52}Al_{0.48}As$ and InP are 0.21 eV and 0.38 eV relative to $In_{0.53}Ga_{0.47}As$, respectively. Therefore, these material systems meet the aforementioned condition that Valence-band offset energies of the cap layers 4 and 9 are increased in a step-wise manner from a boundary interface of the light absorbing layer 3. Especially, the Valence band discontinuity ( ΔEv) for InAlAs relative to InGaAs is approximately half that for InP relative to InGaAs, so that an effect similar to the effect of the graded cap layer 4 in the first embodiment is obtained solely by the intermediate cap layer 9. Next, a diffusion of Zn is carried out at a temperature of 520° C for 16 to 18 minutes by a depth of 1.2 to 1.6 μm by use of a preferential diffusion circular mask having a diameter of 20 μm obtained from a SiO₂ film which is deposited with a thickness of 200ηm at a temperature of 370° C by a thermal CVD process, so that a $p^+$-diffused region 5 is formed in a partial thickness or the entire thickness of the cap layer 4 and the intermediate cap layer 9. Next, an insulation film 6 of SiN is deposited with a thickness of 200 ηm at a temperature of 250° C for 8 minutes on the $n^-$-cap layer 4 and the $p^+$-conduction region 5 by a plasma CVD process, and a p-electrode 7 of AuZn and an n-electrode 8 of AuGe are provided by a vacuum evaporation process. In the provision of the intermediate cap layer 9, the position control of a p-n junction in forming the $p^+$-conduction region 5 is relieved from an order of less than 0.1 μm in the conventional PIN semiconductor light receiving device to an order of less than 0.4 μm.

In the process of the first embodiment in which the $n^-$-graded cap layer 4 is composed of InGaAsP ~ InP, the exchange of column V material gases which largely affects a quality of a crystal on a heterojunction interface at the time of a crystal growth is carried out. Therefore, a specific consideration must be taken in a crystal growth method in the first embodiment. In the second embodiment, the intermediate cap layer 9 can be alternatively exchanged to a graded layer which is composed of InGaAlAs, instead of InAlAs. In such a case, there is obtained an advantage that the intermediate graded layer of InGaAlAs is relatively easy to be grown, because a composition ratio between Al and Ga can be changed only by exchanging column III material gases. Further, there is obtained an additional advantage that the surface oxidation of the InAlAs intermediate cap layer 9 can be avoided in the presence of the cap layer 4. Therefore, the same process as in fabricating a conventional InP/InGaAs system PIN photodiode can be adopted.

In the first and second embodiments, planar structure PIN photodiodes each having a cut-off frequency of more than 20 GHz which is determined by a transit time limitation of hole-carriers is obtained with a good reproducibility. The p-n junctions of the PIN photodiodes are observed in InGaAsP layer (the first embodiment) and the InAlAs layer (the second embodiment) in accordance with an electron beam induced current (EBIC) image observation. No response degradation is found in both the the first embodiment and the second embodiment due to hole interruption at a heterobarrier and no tail is found in pulse response waveforms. Further, no increase of dark current is resulted, because the p-n junction interface is not subject to the exposure of mesa-etching. Therefore, a high reliability is obtained to the same extent as in the conventional planar structure PIN photodiode.

In the PIN semiconductor light receiving devices illustrated embodying the invention it is not necessary for the position of a p-n junction to be controlled with high precision in manufacturing the devices. Nevertheless a device of high speed response can be obtained.

Although the invention has been described with respect to specific embodiment for complete and clear disclosure, the appended claims are not to thus limited.

## Claims

1. A PIN semiconductor light receiving device, comprising:
a semiconductor substrate of a type selected from a first conduction type and a semi-insulation type;
a buffer layer of said first conduction type provided on said semiconductor substrate;
a light absorbing layer of said first conduction type provided on said buffer layer;
a cap layer of said first conduction type provided on said light absorbing layer; and
a conduction region of a second conduction type formed in a predetermined depth of said cap layer;
wherein a Valence-band offset energy of said cap layer is increased as a distance is increased from a boundary interface between said light absorbing layer and said cap layer

2. A PIN semiconductor light receiving device, according to claim 1:
wherein said cap layer is of a graded cap layer selected from InGaAsP ~ InP and InGaAlAs ~ InAlAs to provide a continuous increase of said Valence-band offset energy

3. A PIN semiconductor light receiving device, according to claim 1:
wherein said cap layer includes an intermediate cap layer of InAlAs and a cap layer of InP to provide a step-like increase of said Valence-band offset energy.

# FIG. 1 PRIOR ART

LIGHT INPUT

6 INSULATION LAYER

7 p-ELECTRODE

5 $p^+$-Zn DIFFUSION REGION

4 $n^-$InP WINDOW CAP LAYER

d

3 $n^-$-InGaAs LIGHT ABSORBING LAYER

2 n-InP BUFFER LAYER

1 $n^+$-InP SUBSTRATE

8 n-ELECTRODE

EP 0 347 157 A2

# FIG.2

LIGHT INPUT

6 INSULATION LAYER

7 p-ELECTRODE

5 $p^+$-CONDUCTION REGION

4 $n^-$-GRADED CAP LAYER

3 $n^-$-LIGHT ABSORBING LAYER

2 n-BUFFER LAYER

1 $n^+$-SEMICONDUCTOR SUBSTRATE

8 n-ELECTRODE

EP 0 347 157 A2

# FIG. 3

LIGHT INPUT

6 INSULATION LAYER

7 p-ELECTRODE

5 $p^+$-CONDUCTION REGION

4 $n^-$ CAP LAYER

9 $n^-$-INTERMEDIATE CAP LAYER

3 $n^-$-LIGHT ABSORBING LAYER

2 n-InP BUFFER LAYER

1 $n^+$-InP SUBSTRATE

8 n-ELECTRODE

EP 0 347 157 A2

# FIG. 4

10 p-n JUNCTION

9 n⁻-INTERMEDIATE CAP LAYER

11 BAND STRUCTURE IN CASE OF
VALENCE BAND DISCONTINITY
CHANGING CONTINUOUSLY

3 n⁻-LIGHT ABSORBING LAYER

5 p⁺-CONDUCTION
REGION

1 n⁺-SEMICONDUCTOR SUBSTRATE

2 n-BUFFER LAYER

EP 0 347 157 A2